# DEMANDE DE BREVET EUROPEEN

(11) **EP 1 878 694 A2**
(43) Date de publication de la demande: **16.01.2008**
(21) Numéro de dépôt: 07112226.1
(22) Date de dépôt: 11.07.2007
(51) Int. Cl.: B82B 3/00, H01L 21/18

(54) **Procédé de nanostructuration de la surface d'un substrat**

(30) Priorité: 13.07.2006 FR 0652981
(71) Demandeur: COMMISSARIAT A L'ENERGIE ATOMIQUE, 75015 Paris (FR); Université Jean-Monnet, 42100 Saint Etienne (FR); Centre National de la Recherche Scientifique, 75016 Paris (FR)
(72) Inventeur: Fournel, Frank, 38190, VILLARD BONNOT (FR); Meziere Jérôme, 38000, GRENOBLE (FR); Bavard, Alexis, 38000, GRENOBLE (FR); Pigeon, Florent, 42000, SAINT ETIENNE (FR); Garrelie, Florence, 42000, SAINT ETIENNE (FR)
(74) Mandataire: Poulin, Gérard

(57) **Abrégé**

Il s'agit d'un procédé de réalisation d'une nanostructuration périodique sur une des faces d'un substrat (10) présentant un réseau de dislocations périodique, enterré au sein d'une zone cristalline (4) située au voisinage d'un interface (5) entre des faces en matériau cristallin de deux éléments (1, 2) assemblés par collage pour former le substrat (10). Il comprend les étapes suivantes :
-formation, au niveau des dislocations (3), d'implants (6) en un matériau autre que celui de la zone cristalline (4);
-irradiation avec une onde électromagnétique (11) du substrat (10) pour provoquer une absorption d'énergie électromagnétique localisée au niveau des implants (6), cette absorption conduisant à l'apparition de la nanostructuration (12) périodique sur la face du substrat (10).

## Description

### DOMAINE TECHNIQUE

La présente invention est relative à un procédé de nanostructuration de la surface d'un substrat. Beaucoup d'applications en nanotechnologie utilisent des nanostructures organisées par exemple en microélectronique, en optoélectronique ou en biologie. Ces nanostructures sont généralement obtenues par croissance ou par dépôt sur la surface d'un substrat. On cherche à contrôler de manière aussi précise que possible la densité et la période de ces nanostructures réparties à la surface du substrat.

### ÉTAT DE LA TECHNIQUE ANTÉRIEURE

L'obtention de nanostructures organisées obtenues durant la croissance de nanoparticules, par exemple par épitaxie, sur un substrat est décrite par exemple dans l'article « Self-organized growth of regular nanometer-scale InAs on GaAs » J.M. Moison et al. Appl. Phys. Letter. N°64(2), 10 january 1994, pages 196 à 198 ou dans l'article « Self-organization into 2D and 3D superlattices of nanosized particles differing by their size » L. Motte et al. Journal Phys. Chem. B 1997, 101 pages 138 à 144. Malheureusement, en général, l'ordre spatial obtenu souffre de beaucoup de défauts structuraux notamment de type lacunes, désorientations. D'autres méthodes préconisent de réaliser au préalable une nanostructuration périodique de surface du substrat d'accueil afin d'optimiser la mise en ordre lors de la croissance ou du dépôt, cette nanostructuration peut être une prégravure comme décrit dans l'article « Controlled arrangement of self-organized Ge islands on patterned Si(001) substrates » G. Lin et al. Applied Physics Letters, vol.75, N°18, pages 2752 à 2754 ou par exemple dans l'article « Templated Self-Assembly of Block Copolymers : Effect of substrate Topography » Joy Y. Cheng et al. Advanced Materials 2003, 15, n°19 october 2, pages 1599-1602. Par nanostructuration périodique de surface, on veut dire que l'on réalise des motifs périodiques à l'échelle nanométrique en surface du substrat d'accueil. La réalisation d'une prégravure du substrat d'accueil est un moyen simple de maîtriser la mise en ordre spatiale des nanostructures lors de l'étape de croissance ou de dépôt. Cette prégravure conduit à une nanostructuration topographique du substrat de départ, c'est-à-dire une réalisation de motifs périodiques en relief.

De nombreuses méthodes sont connues pour faire cette nanostructuration périodique de surface. On peut par exemple utiliser des techniques standard en microélectronique telles que la lithographie et la gravure ionique. Malheureusement ces méthodes sont longues et difficilement utilisables en industrie pour la gravure de grandes surfaces de l'ordre de quelques millimètres carrés.

On connaît aussi dans les demandes de brevet FR-A-2 766 620 et FR-A-2 815 121 et dans l'article « Fabrication of nanoperiodic surface structures by controlled etching of dislocations in bicrystals » Rikard A. Wind et al., Applied Physics Letters, volume 78, Number 15, 9 april 2001, pages 2205 à 2207, une méthode qui utilise la gravure préférentielle des défauts cristallins et/ou des champs de contrainte d'un réseau de dislocations afin d'obtenir cette nanostructuration périodique de surface. Le réseau de dislocations est créé en collant, par exemple par adhésion moléculaire, un substrat cristallin avec un autre substrat cristallin, de préférence ce dernier prenant la forme d'un film cristallin très mince dont l'épaisseur typique est de l'ordre de quelques nanomètres. Le collage se fait de manière à obtenir des liaisons covalentes entre les deux réseaux cristallins des faces à assembler. On obtient un arrangement pourvu d'un joint de grains à l'interface de collage et ce joint de grains provoque ainsi l'apparition d'un réseau de dislocations dont les caractéristiques : orientation, période, type de dislocations, symétrie, ne dépendent que des caractéristiques des mailles cristallines du substrat et du film ainsi que des angles de désorientation en torsion et en flexion introduits lors du collage. Par exemple, en partant d'un film et d'un substrat de silicium dont les faces à assembler sont orientées dans la direction <001>, sans désorientation de flexion et avec une désorientation de torsion de 0,88°, on obtient un réseau carré de dislocations dites vis (screw dislocations en anglais) orienté suivant l'orientation <011> moyenne des deux cristaux mis en jeu avec une période de 25 nanomètres. Si le film de silicium est suffisamment mince, par exemple d'épaisseur inférieure à environ 5 nanomètres, le champ de dislocation vis se propage en surface du film de silicium. On peut alors graver préférentiellement la surface en utilisant un moyen de gravure sensible aux champs de contraintes. On obtient alors une nanostructuration périodique de surface de l'arrangement obtenu en relation avec le réseau de dislocations sous-jacent. On peut être amené à amincir l'arrangement obtenu pour éliminer le réseau de dislocations à la fin de l'étape de gravure sélective. Cette topographie peut alors à elle seule entraîner l'apparition de sites de nucléation localisés et périodiques aptes à servir de soubassement pour la croissance ou le dépôt de nanostructures.

Avec la maîtrise des angles de collage, on maîtrise la période du réseau de dislocations et donc la période de la nanostructuration. On peut ainsi ajuster la distance entre les sites de nucléation et donc la période et la densité des nanostructures qui seront supportées par les dits sites de nucléation. Cette technique a pour avantage d'être rapide puisque l'on grave sélectivement l'ensemble de la surface de l'arrangement obtenu par le collage, cette surface pouvant correspondre à celle d'un substrat microélectronique ayant typiquement un diamètre de 300 millimètres. Son inconvénient est que la gravure sélective a tendance à rendre rugueuse la surface des sites de nucléation. Cette rugosité est ensuite très gênante lors de la croissance ou le dépôt ultérieur des nanostructures.

### EXPOSÉ DE L'INVENTION

La présente invention a justement comme but de proposer un procédé de nanostructuration périodique de la surface d'un substrat qui ne présente pas les inconvénients mentionnés ci-dessus. Plus précisément le procédé de l'invention permet d'obtenir, avec une grande précision, un réseau périodique de motifs structuraux en surface du substrat. Ce réseau est réalisé aisément sur de grandes surfaces et la surface des sites de nucléation est aussi lisse que possible, ce qui est favorable à la croissance ou au dépôt de nanostructures sur les motifs.

Pour atteindre ces buts, l'invention concerne plus précisément un procédé de réalisation d'une nanostructuration périodique sur une des faces d'un substrat présentant un réseau de dislocations périodique enterré au sein d'une zone cristalline située au voisinage d'une interface entre des faces en matériau cristallin de deux éléments assemblés par collage pour former le substrat. Il comporte les étapes suivantes :
- formation au niveau des dislocations d'implants en un matériau autre que celui de la zone cristalline ;
- irradiation du substrat avec une onde électromagnétique pour provoquer une absorption d'énergie électromagnétique localisée au niveau des implants, cette absorption conduisant à l'apparition de la nanostructuration périodique sur la face du substrat.

La nanostructuration périodique est topographique ou thermique.

En irradiant le substrat de manière brève, de façon à limiter les effets thermiques, on peut provoquer une ablation d'au moins une partie des implants entraînant une exfoliation d'au moins le matériau cristallin de la zone cristalline face aux implants, entre les implants et la face du substrat, cette ablation et cette exfoliation contribuant à former la nanostructuration. L'irradiation brève signifie dans ce contexte de l'ordre d'une ou plusieurs femtosecondes.

En variante, en irradiant le substrat de manière plus prolongée, on peut provoquer une augmentation de température de la face par des effets thermiques. Cette augmentation de température peut être inhomogène au niveau des implants et au niveau de la zone cristalline située entre les implants. Dans ce contexte, l'irradiation de manière plus prolongée signifie de l'ordre d'une ou de quelques picosecondes voire de l'ordre d'une ou de quelques nanosecondes.

L'augmentation inhomogène de température peut engendrer une déformation plastique ou une exfoliation du matériau cristallin situé face aux implants, entre les implants et la face du substrat, la déformation ou l'exfoliation contribuant à former la nanostructuration.

L'augmentation de température peut engendrer l'apparition, sur la face du substrat, de zones plus affectées thermiquement en regard des implants, ces zones étant plus chaudes, ces zones plus affectées thermiquement avoisinant des zones moins affectées thermiquement, c'est-à-dire moins chaudes, ces zones plus affectées thermiquement et moins affectées thermiquement pouvant former la nanostructuration.

On peut réaliser une attaque préférentielle des zones plus affectées thermiquement vis-à-vis des zones moins affectées thermiquement, de manière à obtenir une nanostructuration topographique.

On peut réaliser un dépôt préférentiel sur les zones plus affectées thermiquement vis-à-vis des zones moins affectées thermiquement, de manière à ce que la nanostructuration soit topographique.

En variante, on peut réaliser un dépôt à base d'un matériau à changement de phase sur la face du substrat avant l'irradiation, ce matériau ce matériau conduisant à la nanostructuration.

Les implants peuvent être obtenus en faisant diffuser thermiquement un matériau métallique déposé au préalable sur l'une des faces du substrat.

Le procédé consiste à ôter le matériau métallique restant sur la face ayant reçu le dépôt, avant l'irradiation avec l'onde électromagnétique.

Le matériau métallique des implants peut être réalisé à base d'or, de titane, d'aluminium, de platine, de cuivre, de tungstène, de nickel, d'argent.

En variante, il est possible de procéder à une implantation ionique dans le substrat d'une espèce que l'on fait diffuser thermiquement pour obtenir les implants.

L'espèce implantée peut être choisie parmi l'or, le titane, l'aluminium, le cuivre, le platine, le tungstène, le nickel, l'argent ou un dopant du matériau cristallin.

On peut procéder à une étape de chauffage homogène du substrat avant et/ou pendant l'irradiation, le dépôt ou l'attaque pour favoriser la migration des espèces et favoriser l'attaque chimique.

L'exfoliation peut entraîner un dépôt de matière exfoliée sur la face du substrat, il possible de prévoir alors une étape de retrait de la matière exfoliée par brossage, nettoyage chimique ou mégasonique.

En variante, il est possible de revêtir la face du substrat avec une couche sacrificielle de manière à ce que, lors de l'exfoliation, de la matière exfoliée se dépose sur la couche sacrificielle, puis d'éliminer la couche sacrificielle ainsi que la matière exfoliée qui s'y est déposée.

Le matériau cristallin des éléments peut être choisi parmi le silicium, les matériaux III-V comme l'arséniure de gallium, l'arséniure d'indium ou le nitrure d'aluminium, les matériaux II-VI comme que le tellure de cadmium ou le séléniure de zinc, ou bien le germanium, le nitrure de gallium, le germanium-silicium SiₓGe_{y}, le carbure de silicium, le phosphure d'indium, le saphir, le quartz, les grenats, le diamant.

L'un des éléments est de préférence un film qui se trouve du côté de la face du substrat doté de la nanostructuration, ce qui permet aux dislocations d'être proches d'une des faces du substrat.

L'onde électromagnétique peut être pulsée ou continue.

L'onde électromagnétique peut être monochromatique ou quasi monochromatique ou comporter une ou plusieurs longueurs d'ondes. Lorsqu'elle comporte plusieurs longueurs d'ondes, ces dernières peuvent être émises en même temps ou successivement, l'onde électromagnétique étant alors subdivisée en plusieurs parties correspondant aux différentes longueurs d'ondes, ces parties ayant des intensités égales ou différentes.

Le procédé de nanostructuration périodique peut être réalisé sous atmosphère contrôlée ou au sein d'un liquide de manière à contrôler l'exfoliation et/ou faciliter la structuration.

La présente invention concerne également un procédé de réalisation de nanostructures qui comprend une étape de dépôt d'un matériau sur un substrat doté d'une nanostructuration obtenue par le procédé ainsi caractérisé.

En cas de nanostructuration formée de zones affectées thermiquement et de zones moins affectées thermiquement, le dépôt des nanostructures peut se faire par exemple par jet moléculaire en profitant d'une vitesse de croissance différente entre les dites zones.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
les figures 1A à 1G montrent différentes étapes d'un exemple d'un procédé selon l'invention ;
les figures 2A à 2E montrent des étapes d'un autre exemple du procédé de l'invention ;
les figures 3A à 3E montrent encore d'autres étapes d'un exemple du procédé de l'invention ;
la figure 4 illustre des profils d'implantation utilisés pour réaliser les implants.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

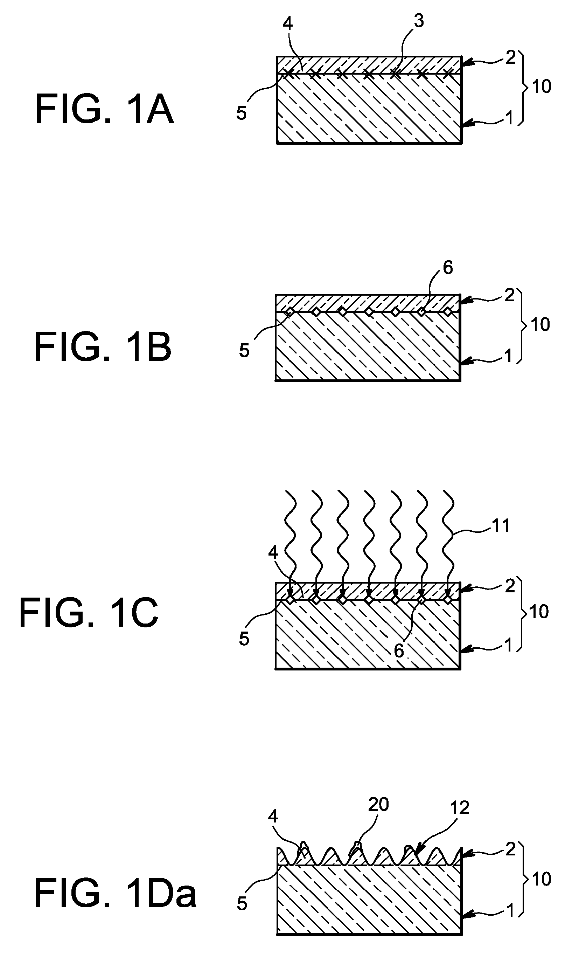

On va maintenant en se référant aux figures 1A à 1G décrire un exemple de procédé selon l'invention. On part d'un substrat 10 possédant un réseau de dislocations 3 enterré. Ce substrat 10 peut être obtenu par exemple comme décrit dans la demande de brevet FR-A-2 766 620. On peut par exemple commencer par coller par adhésion moléculaire une face en matériau monocristallin d'un premier élément 1 contre une face en matériau monocristallin d'un second élément 2. On fait en sorte que les deux faces présentent des réseaux cristallins décalés en rotation et/ou en flexion et/ou un désaccord de paramètre de maille, de manière à faire apparaître ce réseau de dislocations 3 au sein d'une zone cristalline 4 située au voisinage de l'interface 5 de collage. Le substrat de départ 10 est illustré sur la figure 1A. L'un des éléments 2 peut être plus mince que l'autre, il peut s'agir de préférence d'un film mince cristallin ayant par exemple une épaisseur inférieure à environ 10 micromètres. Il est possible qu'au moment du collage, on ne dispose pas du film mince mais que celui-ci soit obtenu ultérieurement par amincissement de l'élément correspondant.

Cet élément peut notamment être un substrat composite formé d'un empilement d'un support, d'une couche d'arrêt à l'amincissement, d'un film mince cristallin. Il peut s'agir notamment d'un substrat SOI (acronyme anglo-saxon semiconductor on insulator soit semi-conducteur sur isolant). On peut prévoir comme dans la demande de brevet FR-A-2 819 099 que le film mince ait été prélevé, au préalable, dans un substrat de base cristallin, ce qui reste du substrat de base après le prélèvement donnant l'autre élément. Le prélèvement peut se faire par réalisation d'une zone fragilisée enterrée obtenue par exemple par implantation ionique (par exemple d'hydrogène), dans le substrat de base puis fracture au niveau de la zone fragilisée.

On va ensuite répartir dans le substrat 10 au niveau de chaque dislocation 3 des implants 6 en un matériau différent que celui de la zone cristalline 4 dans laquelle se trouvent les dislocations 3 (figure 1B).

On va par la suite irradier une face du substrat 10 avec une onde électromagnétique 11 qui va entrer en interaction forte avec les implants 6 tandis que le matériau de la zone cristalline 4 autour des implants 6 sera soumis à une interaction plus faible. On peut se référer à la figure 1C. Cette interaction va conduire à la nanostructuration périodique en surface du substrat 10. L'onde électromagnétique peut être délivrée par un laser (non représenté). Elle peut être continue ou préférentiellement en impulsions. Les impulsions peuvent être brèves, très avantageusement de l'ordre d'une ou quelques femtosecondes ou bien temporellement plus étalées, de l'ordre d'une ou quelques picosecondes ou d'une ou quelques nanosecondes. En continu, on retrouvera les mêmes mécanismes qu'en pulsé lent.

Elle peut être monochromatique ou quasi monochromatique ou au contraire posséder plusieurs longueurs d'ondes. Lorsque l'onde électromagnétique utilisée pour l'irradiation possède plusieurs longueurs d'ondes, ces longueurs d'ondes peuvent être émises successivement ou simultanément. Lorsque l'onde électromagnétique utilisée pour l'irradiation possède plusieurs longueurs d'ondes, elle est subdivisée en plusieurs parties selon les différentes longueurs d'ondes, ces parties ayant des intensités égales ou différentes.

On va expliquer maintenant comment la nanostructuration périodique en surface peut être obtenue.

Plusieurs phénomènes peuvent se produire en fonction de la durée de l'irradiation. Si celle-ci est très brève, par exemple est délivrée par un laser femtoseconde, il se produit une ablation des implants 6 entraînant une exfoliation de la matière sus-jacente aux implants 6 sans échange significatif de chaleur. La nanostructuration 12 périodique est topographique comme illustré sur les figures 1Da, 1Db. C'est la faible durée de l'irradiation qui permet de limiter les effets thermiques.

Il est ensuite possible de prévoir une étape de retrait de la matière exfoliée 20 qui pourrait se redéposer sur le substrat 10. En principe les implants 6 sont atomisés et donc disparaissent, cependant il se peut que seulement une partie de l'implant disparaisse entraînant l'exfoliation de ce qu'il y a dessus et laisse intact ce qu'il y a dessus, y compris une partie de l'implant.

Ce retrait peut se faire par des techniques classiques en microélectronique telles que le brossage, le nettoyage chimique et/ou mégasonique.

On suppose que le substrat 10 représenté sur la figure 1Da est vu avant l'étape de nettoyage. Le résultat après nettoyage est représenté sur la figure 1Db.

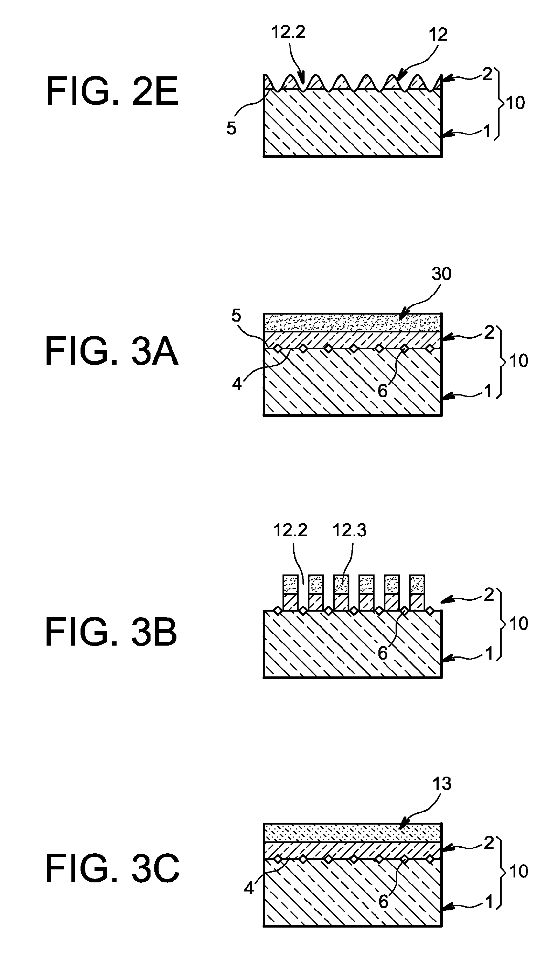

Il est possible de prévoir une étape de dépôt d'une couche sacrificielle 30 sur le substrat 10, du côté de sa face qui va être irradiée mais avant l'irradiation (figure 3A). Après l'irradiation, de la matière exfoliée 20 va retomber sur la couche sacrificielle 30. Par une étape de décollement (connue sous la dénomination anglo-saxonne de lift-off), on pourra retirer la couche sacrificielle 30 et la matière exfoliée 20 qui s'est déposée dessus. On obtiendra une configuration similaire à celle de la figure 1Db. Le matériau de la couche sacrificielle 30 peut par exemple être de l'oxyde de silicium.

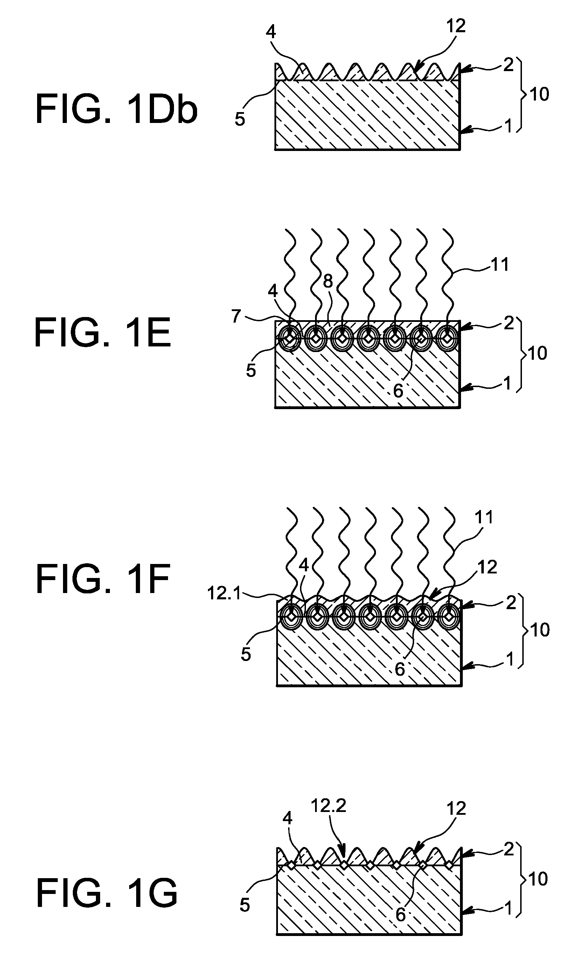

Si l'irradiation se prolonge, les impulsions ayant une durée de l'ordre d'une ou quelques picosecondes ou nanosecondes, l'absorption localisée de l'onde électromagnétique par les implants 6 crée une augmentation de température au niveau des implants 6. Cette augmentation de température localisée est illustrée schématiquement sur la figure 1E par les cercles concentriques. La nanostructuration 12 surfacique peut être provoquée par la dilatation du matériau des implants 6 et/ou du matériau de la zone cristalline 4 qui entoure les implants 6 et en conséquence par la déformation du matériau sus-jacent aux implants 6. La nanostructuration 12 est alors une nanostructuration topographique. Il se forme des saillies 12.1 face aux implants 6. Cette déformation se produit en premier, sur la face du substrat la plus proche des implants, dans l'exemple décrit côté film mince 2 parce que son épaisseur permet la propagation de cette déformation. Cette configuration est illustrée sur la figure 1F. La déformation peut notamment être plastique, c'est-à-dire permanente ou irréversible, elle subsiste après l'arrêt de l'irradiation avec l'onde électromagnétique 11.

La déformation peut même conduire à une exfoliation du matériau sus-jacent aux implants 6 comme illustré sur la figure 1G. Il se forme alors des creux 12.2 face aux implants 6.

L'augmentation de température est inhomogène au niveau des implants 6 et au niveau de la zone cristalline 4 entre les implants. Il se crée des zones plus affectées thermiquement 7 (c'est à dire des zones plus chaudes) avoisinant des zones moins affectées thermiquement 8 (c'est-à-dire des zones moins chaudes).

Ces zones sont représentées sur la figure 1E. Il est possible que les zones plus affectées thermiquement 7 et les zones 8 moins affectées thermiquement en surface forment à elles seules la nanostructuration surfacique périodique. Cette nanostructuration 12 est alors thermique et non plus topographique. Une étape de dépôt ou de gravure pourra avoir lieu directement à la surface du substrat 10 possédant cette nanostructuration thermique. Une étape de gravure est illustrée à la figure 3B décrite ultérieurement.

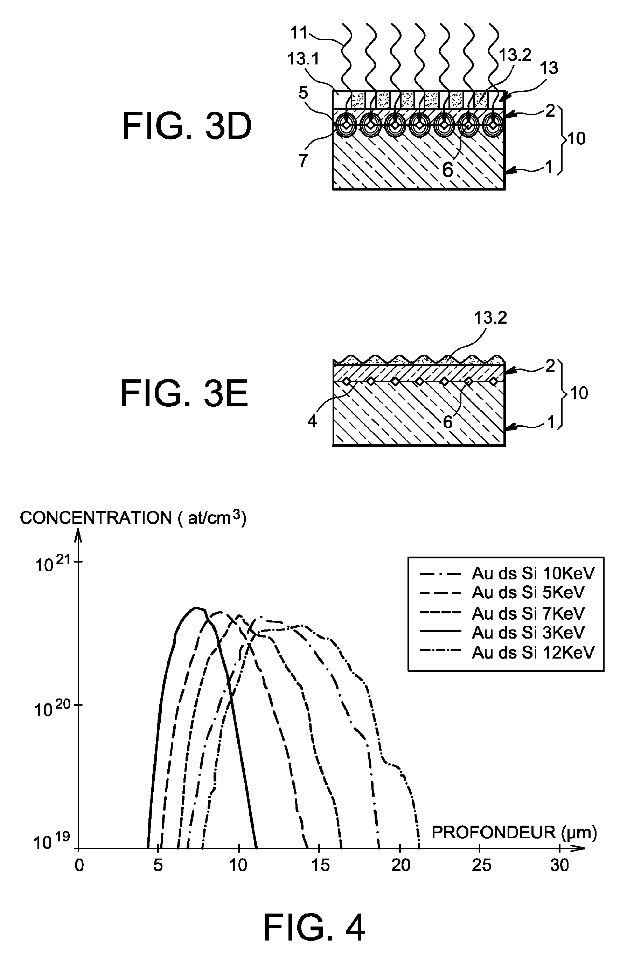

Une étape de dépôt peut se faire par jet moléculaire, la température en surface du substrat d'accueil 10 influence la façon dont les atomes du matériau cristallin déposé se répartissent. Le dépôt se fait avec des vitesses de croissance différentes en fonction de la température de la zone réceptrice. On obtient avec ce dépôt, une croissance de nanostructures 14 tel qu'illustré sur la figure 3E. Si on dépose un matériau sur la surface d'un substrat présentant une nanostructuration topographique, en fonction de l'affinité entre ce matériau et le matériau en surface du substrat, la matière viendra naturellement se localiser dans les creux s'il y a une grande affinité et sur les bosses, s'il y a peu d'affinité, affin de minimiser l'énergie du système.

Il est possible, en variante, de déposer sur le substrat 10, préalablement à l'irradiation, une couche 13 d'un matériau qui va conduire à la nanostructuration lorsque l'irradiation aura eu lieu comme illustré sur la figure 3C. Ce matériau peut être un matériau à changement de phase en fonction de la température tel que le GeSbTe (germanium antimoine tellure). Après l'irradiation, on obtiendra une juxtaposition de zones amorphes 13.1 et de zones cristallines 13.2 comme illustré sur la figure 3D. La localisation des zones amorphes dépend en fait de l'historique thermique de l'emplacement, de l'état de départ du matériau à changement de phase. En général, on obtient du matériau amorphe quand le refroidissement, après la montée en température, est rapide et du matériau cristallin quand le refroidissement est lent. On peut donc déposer par exemple la matériau à changement de phase sous forme cristalline, élever localement au niveau des implants 6 la température jusqu'à une température suffisante pour assurer la transition et descendre rapidement en température pour obtenir au niveau des implants des zones amorphes. D'autres configurations sont bien sûr possibles.

Avant et/ou pendant la croissance, le dépôt, l'attaque ou l'irradiation, il est possible de chauffer de manière homogène le substrat 10. Cela peut se faire dans un four, l'augmentation de température peut être comprise par exemple entre environ 100°C et 600°C. Cette augmentation de température s'effectue de manière globale. Les gradients locaux de température engendrés par l'irradiation s'ajoutent à la température obtenue par le chauffage homogène. Cette étape n'est pas représentable. Cette étape permet par exemple, dans le cas du matériau à changement de phase, de situer avant irradiation au voisinage de la température de transition du matériau. Elle permet également de favoriser l'attaque.

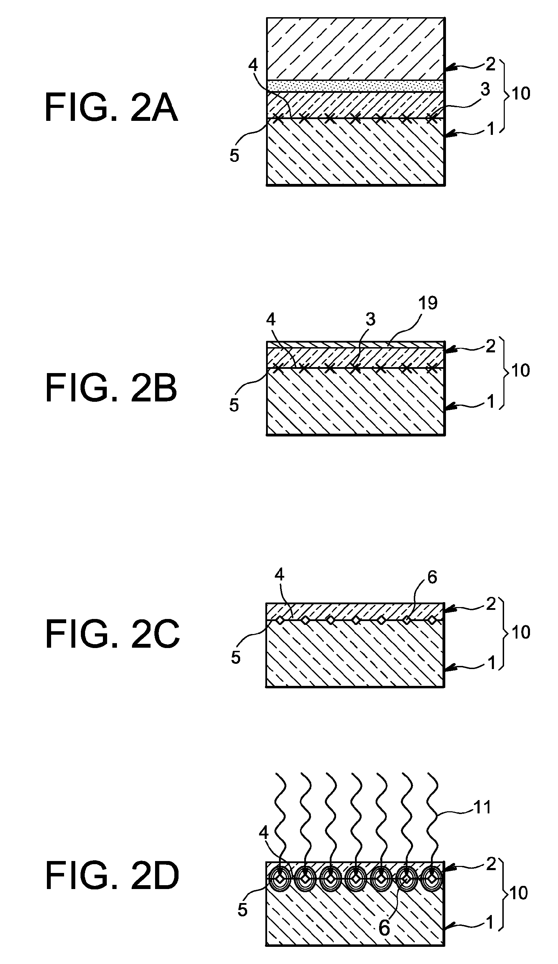

On va voir maintenant plus en détail un exemple de réalisation du procédé de l'invention en se référant aux figures 2A à 2E.

On part d'un substrat 10 formé de deux éléments 1, 2 ayant chacun une face en matériau cristallin, ces faces étant assemblées par collage moléculaire en prévoyant un angle de décalage en rotation de 0,88° entre leurs réseaux cristallins et pas de désorientation en flexion. Le matériau cristallin de ces deux éléments peut être le même par exemple du silicium ou bien être différent. Ce substrat 10 peut être qualifié de « twisté » à cause de l'angle de désorientation en rotation souvent appelé angle de « twist ». On se réfère à la figure 2A qui montre le substrat « twisté » 10 doté du réseau ordonné de dislocations 3 au sein d'une zone cristalline 4 située au voisinage d'interface 5 de collage. On suppose, dans l'exemple décrit, que les faces cristallines des deux éléments 1, 2, sont en silicium. L'un des éléments 1 peut être un substrat en silicium massif et l'autre élément 2 un film mince. En variante, l'autre élément 2 pourra être plus épais au moins au moment de l'assemblage, il comportera du matériau cristallin sur sa face à assembler. Il pourra être composite comme illustré sur la figure 2A. On lui fera subir une étape d'amincissement pour ne garder qu'un film mince 2 dont l'épaisseur sera par exemple d'environ 10 nanomètres. L'amincissement pour ne conserver que le film mince 2 peut se faire tout de suite après l'assemblage ou bien ultérieurement après l'étape de réalisation des implants. Cette étape d'amincissement peut par exemple se faire rectification, par abrasion mécanique ou même par abrasion chimique.

Du silicium peut être employé comme matériau cristallin pour l'un ou l'autre des éléments 1, 2. Il est bien sûr possible d'utiliser d'autres matériaux tels que les matériaux III-V comme l'arséniure de gallium, l'arséniure d'indium ou le nitrure d'aluminium, les matériaux II-VI comme que le tellure de cadmium ou le séléniure de zinc ou le germanium, le nitrure de gallium, le germanium-silicium SiₓGe_{y}, le carbure de silicium, le phosphure d'indium, le saphir, le quartz, les grenats, le diamant.

Pour réaliser les implants 6 au niveau des dislocations 3, on peut déposer en surface du substrat 10, de préférence du côté du film mince 2, une couche 19 de matériau métallique apte à diffuser dans le matériau du cristallin du film mince 2 jusqu'au réseau de dislocations 3 et capable d'absorber fortement une onde électromagnétique utilisée par la suite. Il peut s'agir d'un dépôt chimique en phase vapeur, d'un dépôt électrolytique ou d'une pulvérisation. On peut se référer à la figure 2B. Le dépôt pourrait tout à fait être réalisé du côté du substrat massif 1 dans la mesure où le matériau métallique déposé est capable de diffuser jusqu'au réseau de dislocations 3. Le matériau métallique employé peut être réalisé à base d'or mais d'autres matériaux conviennent également tel le titane, l'aluminium, le platine, le cuivre, le tungstène, le nickel, l'argent.

L'épaisseur de la couche 19 sera égale ou inférieure à environ 15 nanomètres s'il s'agit d'or. On fait ensuite diffuser thermiquement le matériau métallique déposé dans le matériau cristallin de la zone cristalline 4 pour qu'il atteigne les dislocations 6 au moyen de l'application d'un budget thermique avec une température comprise entre environ 100°C et 1000°C, et par exemple de l'ordre de 500°C pendant un laps de temps compris entre environ 1 minute et 10 heures, par exemple pendant 5 heures. En diffusant jusqu'aux dislocations 3, le matériau métallique forme les implants 6.

Après la diffusion du matériau métallique, on ôte ce qui reste de la couche 19 de matériau métallique en surface comme illustré sur la figure 2C. Ce retrait peut se faire par exemple, lorsqu'il s'agit d'or ou de platine, par une attaque chimique humide avec de l'eau régale. On rappelle que l'eau régale est un liquide très oxydant formé d'un mélange d'acides chlorhydrique et nitrique. Elle a la propriété d'attaquer l'or et tous les métaux de la famille du platine. Une attaque sèche de type ionique pourrait aussi être utilisée.

En variante, les implants 6 peuvent aussi être obtenus en réalisant au moins une implantation ionique de l'espèce choisie pour les réaliser, suivie d'une diffusion thermique. L'implantation se fera de préférence du côté du film mince 2. L'espèce implantée peut être notamment choisie parmi l'or, le titane, l'aluminium, le cuivre, le platine, le tungstène, le nickel, l'argent ou des dopants du matériau du film mince 2 (dans l'exemple du silicium) comme par exemple, le bore, l'arsenic. Avantageusement il est possible d'étaler le profil d'implantation en effectuant plusieurs implantations successives à différentes énergies comme dans l'exemple de la figure 4 afin de répartir les contraintes dans la structure. Si l'on implantait trop au même endroit, cela pourrait rendre amorphe localement le matériau, ce qui n'est pas le but recherché. On a représenté sur cette figure cinq implantations d'or successives avec des énergies de 3 KeV, 5 KeV, 7 KeV, 10 KeV, 12 KeV. Le ou les profils d'implantation peuvent se situer moins profondément, au même niveau ou plus profondément que les dislocations 3. Une étape de traitement thermique permet ensuite de faire diffuser les espèces implantées qui naturellement viennent se localiser au niveau des dislocations pour former les implants. Pour ne pas multiplier le nombre de figures inutilement, la figure 2C peut tout à fait illustrer les implants 6 obtenus par implantation ionique.

On irradie par la suite, comme illustré à la figure 2D, le substrat 10 à partir de l'une de ses faces principales avec l'onde électromagnétique 11 pulsée dont la durée d'impulsion peut être plus ou moins longue.

En utilisant une onde électromagnétique continue ou pulsée de grande durée d'impulsion (de l'ordre d'une ou quelques nanosecondes), l'absorption de l'énergie du laser puis la relaxation de cette énergie au sein des matériaux des implants et cristallin se feront par des processus classiques d'absorption puis de relaxation électrons-phonons sur des échelles de temps de l'ordre de la picoseconde, connus sous l'appellation générique "d'effets thermiques". Ces effets thermiques conduisent à une augmentation de la température, pouvant atteindre la température de vaporisation du matériau des implants voire du matériau cristallin. Cette vaporisation du matériau peut intervenir sur des échelles de temps de quelques nanosecondes, dépendant des propriétés physiques et optiques du matériau irradié et des caractéristiques du faisceau laser utilisé. Du fait de la différence de nature entre les implants et le matériau cristallin entre ces implants, des gradients de température pourront être localisés à la surface. La nanostructuration de la surface peut être induite par ces gradients de température ou par la vaporisation des implants. Du fait de la diffusion de la chaleur à la surface du matériau, il est avantageux d'avoir une distance importante entre les implants afin de distinguer en surface les zones thermiquement affectées des zones moins thermiquement affectées. Cette distance est typiquement comprise entre environ 0,1 à 1 micromètre.

En utilisant des impulsions de durée ultra brève (de l'ordre d'une ou quelques femtosecondes, voire d'une ou quelques picosecondes), l'énergie du laser sera absorbée, dans le cas des implants métalliques, par les électrons libres, tandis que pour le matériau cristallin semi-conducteur entre les implants, les électrons seront excités à partir de la bande de valence, ce qui nécessite que l'énergie des photons du laser soit supérieure au gap d'énergie entre la bande de valence et la bande de conduction du matériau cristallin. Suite à l'irradiation de la surface par le laser de durée d'impulsion ultra brève, en particulier en utilisant des densités de puissance pas trop élevées, pour lesquelles des porteurs libres ne pourront pas être créés au sein du matériau cristallin semi-conducteur entre les implants 6 par des processus de photo-ionisation ou d'ionisation par impact électron-électron, des électrons chauds, c'est à dire un plasma électronique, seront créés dans les implants 6, ce qui conduira à une ablation préférentielle de ces implants 6, là où la densité de porteurs libres est la plus élevée et donc à l'exfoliation des zones cristallines sus-jacente au implants 6. En fonction de la densité de puissance du faisceau laser, le plasma pourra être créé, préférentiellement dans la zone où résultera une densité importante d'électrons libres, à la suite de l'apparition d'une densité de charges importante qui induira une avalanche d'ionisation puis un claquage. Les électrons seront portés à très haute température par l'absorption de l'onde électromagnétique de durée ultra-brève, en comparaison du réseau cristallin beaucoup moins absorbant sur ces échelles de temps. Cela pourra conduire à la formation d'une onde de choc des électrons chauds et donc à l'éjection de matière localisée dans les zones où l'onde électromagnétique aura été préférentiellement absorbée. Il est à noter que cette technique permet de minimiser le couplage entre les électrons et les phonons du substrat. Il n'y donc pas ou peu d'élévation de la température moyenne du substrat semi-conducteur.

On obtient alors une nanostructuration 12 surfacique qui possède la même période et la même symétrie que celles du réseau de dislocations 3 du substrat 10 avant traitement. Cette nanostructuration 12 qui est topographique est illustrée en figure 2E, elle possède des creux 12.2 face aux implants 6. Elle correspond au cas où l'irradiation a été menée avec des impulsions très brèves.

On peut par exemple déposer une couche d'oxyde de silicium 30 en surface du substrat 10, après la réalisation des implants 6 mais avant l'irradiation comme illustré à la figure 3A. Une fois l'irradiation appliquée et l'exfoliation obtenue, les creux 12.2 sont sans oxyde mais il reste des zones revêtues d'oxyde 12.3. Par gravure par exemple à l'aide d'une solution à base de TMAH, on peut accentuer le relief des creux 12.2 obtenus vis-à-vis des zones revêtues d'oxyde 12.3 qui elles ne sont pas attaquées comme illustré à la figure 3B. On obtient alors des zones revêtues d'oxyde 12.3 séparées par les creux 12.2. L'oxyde peut être éliminé comme évoqué plus haut surtout si lors de l'irradiation de la matière exfoliée s'est déposée sur les zones revêtues d'oxyde 12.3.

Le procédé de réalisation de la nanostructration qui vient d'être décrit peut avoir lieu sous atmosphère contrôlée par exemple à base de vide, d'oxygène O₂, d'azote N₂, d'argon Ar, d'hélium He, d'hydrogène H₂ ou au sein d'un liquide tel que de l'eau ou tout autre liquide qui n'absorbe pas la longueur d'onde du laser. Cela permet, par exemple, de favoriser l'attaque, de contrôler l'exfoliation.

Bien que plusieurs modes de réalisation de la présente invention aient été représentés et décrits de façon détaillée, on comprendra que différents changements et modifications puissent être apportés sans sortir du cadre de l'invention. Ces différentes possibilités (variantes) doivent être comprises comme n'étant pas exclusives les unes des autres.

## Revendications

1. Procédé de réalisation d'une nanostructuration périodique sur une des faces d'un substrat (10) présentant un réseau de dislocations (6) périodique enterré au sein d'une zone cristalline (4) située au voisinage d'un interface (5) entre des faces en matériau cristallin de deux éléments (1, 2) assemblés par collage pour former le substrat (10), **caractérisé en ce qu'**il comprend les étapes suivantes :
- formation au niveau des dislocations (3) d'implants (6) en un matériau autre que celui de la zone cristalline (4);
- irradiation du substrat (10) avec une onde électromagnétique (11) pour provoquer une absorption d'énergie électromagnétique localisée au niveau des implants (6), cette absorption conduisant à l'apparition de la nanostructuration (12) périodique sur la face du substrat (10).

2. Procédé selon la revendication 1, **caractérisé en ce que** la nanostructuration périodique est topographique ou thermique.

3. Procédé selon l'une des revendications 1 ou 2, **caractérisé en ce que** l'irradiation du substrat (10) est réalisée de manière brève, de manière à provoquer une ablation d'au moins une partie des implants entraînant une exfoliation d'au moins le matériau cristallin de la zone cristalline (4) face aux implants (6), entre les implants (6) et la face du substrat, cette ablation et cette exfoliation contribuant à former la nanostructuration (12).

4. Procédé selon l'une des revendications 1 ou 2, **caractérisé en ce que** l'irradiation du substrat (10) est réalisée de manière prolongée, de manière à provoquer une augmentation de température de la face irradiée, cette augmentation de température étant inhomogène au niveau des implants (6) et au niveau de la zone cristalline (4) située entre les implants.

5. Procédé selon la revendication 4, **caractérisé en ce que** l'augmentation de température engendre une déformation plastique du matériau cristallin situé face aux implants (6), entre les implants (6) et la face du substrat, la déformation contribuant à former la nanostructuration (12).

6. Procédé selon la revendication 4, **caractérisé en ce que** l'augmentation de température engendre une exfoliation du matériau cristallin situé face aux implants (6), entre les implants (6) et la face du substrat, l'exfoliation contribuant à former la nanostructuration (12).

7. Procédé selon la revendication 4, **caractérisé en ce que** l'augmentation de température engendre l'apparition, sur la face du substrat, de zones plus affectées thermiquement (7) (10) en regard des implants (6), ces zones étant les plus chaudes, ces zones plus affectées thermiquement avoisinant des zones moins affectées thermiquement (8), ces zones plus affectées thermiquement et moins affectées thermiquement (7, 8) pouvant former la nanostructuration (12).

8. Procédé selon la revendication 7, **caractérisé en ce qu'**il comporte une attaque préférentielle des zones plus affectées thermiquement (7) vis-à-vis des zones moins affectées thermiquement (8), de manière à obtenir une nanostructuration topographique.

9. Procédé selon la revendication 7, **caractérisé en ce qu'**il comporte un dépôt préférentiel sur les zones plus affectées thermiquement (7) vis-à-vis des zones moins affectées thermiquement (8), de manière à obtenir une nanostructuration topographique.

10. Procédé selon la revendication 7, **caractérisé en ce qu'**il comporte un dépôt à base d'un matériau à changement de phase sur la face du substrat avant l'irradiation.

11. Procédé selon l'une des revendications 1 à 10, **caractérisé en ce que** les implants (6) sont obtenus en faisant diffuser thermiquement un matériau métallique déposé au préalable sur l'une des faces du substrat (10).

12. Procédé selon la revendication 11, **caractérisé en ce qu'**il comporte une étape destinée à ôter le matériau métallique restant sur la face ayant reçu le dépôt, avant l'irradiation avec l'onde électromagnétique (11).

13. Procédé selon l'une des revendications 11 ou 12, **caractérisé en ce que** le matériau métallique des implants est réalisé à base d'or, de titane, d'aluminium, de platine, de cuivre, de tungstène, de nickel, d'argent.

14. Procédé selon l'une des revendications 1 à 10, **caractérisé en ce qu'**il comporte une étape d'implantation ionique dans le substrat d'une espèce que l'on fait diffuser thermiquement pour obtenir les implants.

15. Procédé selon la revendication 14, **caractérisé en ce que** l'espèce implantée est choisie parmi l'or, le titane, l'aluminium, le cuivre, le platine, le tungstène, le nickel, l'argent ou un dopant du matériau cristallin.

16. Procédé selon la revendication 1 ou 8 ou 9 ou 10, **caractérisé en ce qu'**il comporte une étape de chauffage homogène du substrat (10) avant et/ou pendant l'irradiation, le dépôt ou l'attaque.

17. procédé selon l'une des revendications 3 ou 6, dans lequel l'exfoliation entraîne un dépôt de matière exfoliée sur la face du substrat (10), **caractérisé en ce qu'**il comporte une étape de retrait de la matière exfoliée par brossage, nettoyage chimique ou mégasonique.

18. Procédé selon l'une des revendications 3 ou 6, **caractérisé en ce qu'**il comporte une étape destinée à revêtir la face du substrat avec une couche sacrificielle de manière à ce que, lors de l'exfoliation, de la matière exfoliée se dépose sur la couche sacrificielle, puis à éliminer la couche sacrificielle ainsi que la matière exfoliée déposée sur elle.

19. Procédé selon l'une des revendications 1 à 18, **caractérisé en ce que** le matériau cristallin des éléments (1, 2) est choisi parmi le silicium, les matériaux III-V comme l'arséniure de gallium, l'arséniure d'indium ou le nitrure d'aluminium, les matériaux II-VI comme que le tellure de cadmium ou le séléniure de zinc, ou bien le germanium, le nitrure de gallium, le germanium-silicium SiₓGe_{y}, le carbure de silicium, le phosphure d'indium, le saphir, le quartz, les grenats, le diamant.

20. Procédé selon l'une des revendications 1 à 19, **caractérisé en ce que** l'un des éléments (2) est un film, cet élément se trouvant du côté de la face du substrat dotée de la nanostructuration.

21. Procédé selon l'une des revendications 1 à 20, **caractérisé en ce que** l'onde électromagnétique (11) est pulsée ou continue.

22. Procédé selon l'une des revendications 1 à 21, **caractérisé en ce que** l'onde électromagnétique (11) est monochromatique ou quasi monochromatique ou comporte une ou plusieurs longueurs d'ondes, lorsqu'elle comporte plusieurs longueurs d'onde électromagnétiques, ces dernières sont émises en même temps ou successivement, l'onde électromagnétique (11) étant alors subdivisée en plusieurs parties selon les différentes longueurs d'ondes, ces parties ayant des intensités égales ou différentes.

23. Procédé selon l'une des revendications 1 à 22, **caractérise en ce qu'**il est réalisé sous atmosphère contrôlée ou au sein d'un liquide.

24. Procédé de réalisation de nanostructures (14), **caractérisé en ce qu'**il comporte une étape de dépôt d'un matériau (9) sur un substrat (10) doté d'une nanostructuration obtenue par le procédé selon l'une des revendications 1 à 23.

25. Procédé selon la revendication 24, **caractérisé en ce que**, en cas de nanostructuration formée de zones plus affectées thermiquement (7) et de zones moins affectées thermiquement (8), le dépôt des nanostructures se fait par jet moléculaire.
